(19) Europäisches Patentamt
European Patent Office
Office européen des brevets

(11) Publication number: **0 206 136 B1**

(12) **EUROPEAN PATENT SPECIFICATION**

(45) Date of publication of patent specification: **03.07.91**

(51) Int. Cl.5: **H01L 21/302**, H01L 21/306, H01L 29/743

(21) Application number: **86108001.8**

(22) Date of filing: **12.06.86**

(54) Semiconductor device manufacturing method.

(30) Priority: **12.06.85 JP 127502/85**

(43) Date of publication of application:
**30.12.86 Bulletin 86/52**

(45) Publication of the grant of the patent:
**03.07.91 Bulletin 91/27**

(84) Designated Contracting States:
**CH DE FR GB LI**

(56) References cited:

**PROCEEDINGS OF THE IRE, vol. 46, no. 6, June 1958, pages 1062-1067; H. NELSON: "The preparation of semiconductor devices by lapping and diffusion techniques"**

**PATENT ABSTRACTS OF JAPAN, vol. 9, no. 230 (E-343)[1953], 17th September 1985; & JP-A-60 85 563 (MITSUBISHI DENKI K.K.) 15-05-1985**

**IEEE TRANSACTIONS ON ELECTRON DEVICES, vol. ED-31, no. 12, December 1984, pages 1681-1686, IEEE, New York, US; T. YATSUO et al.: "Ultrahigh-voltage high-current**

gate turn-off thyristors"

(73) Proprietor: **KABUSHIKI KAISHA TOSHIBA
72, Horikawa-cho Saiwai-ku
Kawasaki-shi Kanagawa-ken 210(JP)**

(72) Inventor: **Fujiwara, Takashi Patent Division
K.K. Toshiba 1-1 Shibaura 1-chome
Minato-ku Tokyo 105(JP)**
Inventor: **Tanoue, Ryoji Patent Division
K.K. Toshiba 1-1 Shibaura 1-chome
Minato-ku Tokyo 105(JP)**

(74) Representative: **Lehn, Werner, Dipl.-Ing. et al
Hoffmann, Eitle & Partner Patentanwälte Arabellastrasse 4
W-8000 München 81(DE)**

## Description

This invention relates to a semiconductor device manufacturing method and more particularly to a method for manufacturing an anode-emitter shorting type gate turn-off thyristors (AN-GTO).

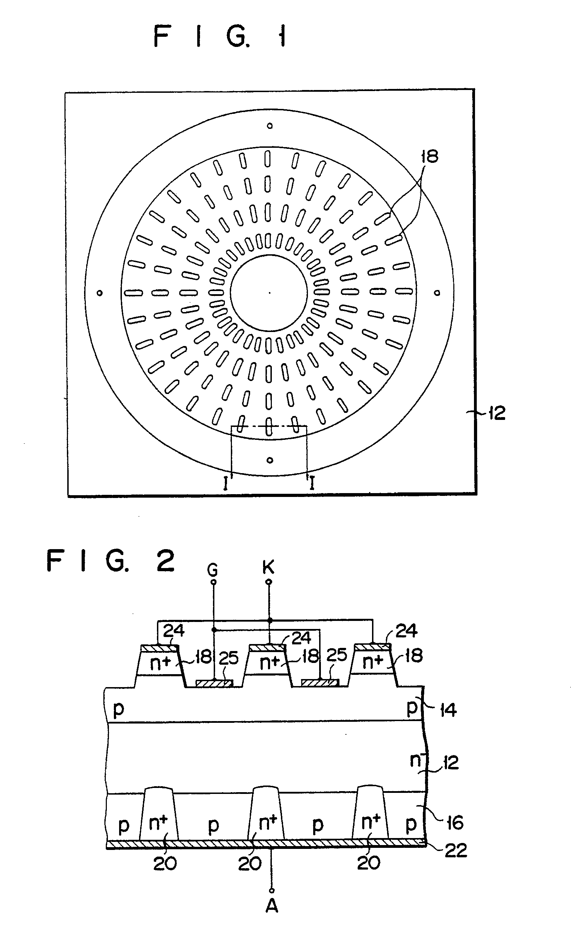

The structure of an already known AN-GTO will be described with reference to Figs. 1 and 2. Fig. 1 shows a top view of AN-GTO. Fig. 2 shows a cross sectional view taken on line I - I of Fig. 1. In manufacturing the AN-GTO, for example, an $n^-$-type semiconductor substrate 12 is prepared. This AN-GTO includes p-type region 14 formed in the upper surface of substrate 12, and p-type region 16 formed in the bottom surface of substrate 12. The p-type region 16 is used as the anode-emitter of the AN-GTO. The cathode emitter of the AN-GTO is composed of radially distributed $n^+$-type regions 18, as shown in the Fig. 1. $n^+$-type regions 18 are obtained by patterning an n-type region (not shown) which is formed on the entire surface of p-type region 14. The AN-GTO includes $n^+$-type regions 20 in the bottom surface of the n-type substrate. The regions 20 serve as shorting sections. The $n^+$-type regions 20, as shown in Fig. 2, are located under the bottom of $n^+$-type regions 18. Anode electrode 22 of the AN-GTO is formed in contact with $n^+$-type regions 20 and p-type region 16. Cathode electrodes 24 are formed in contact with $n^+$-type regions 18. Gate electrodes 25 are formed in contact with p-type region 14.

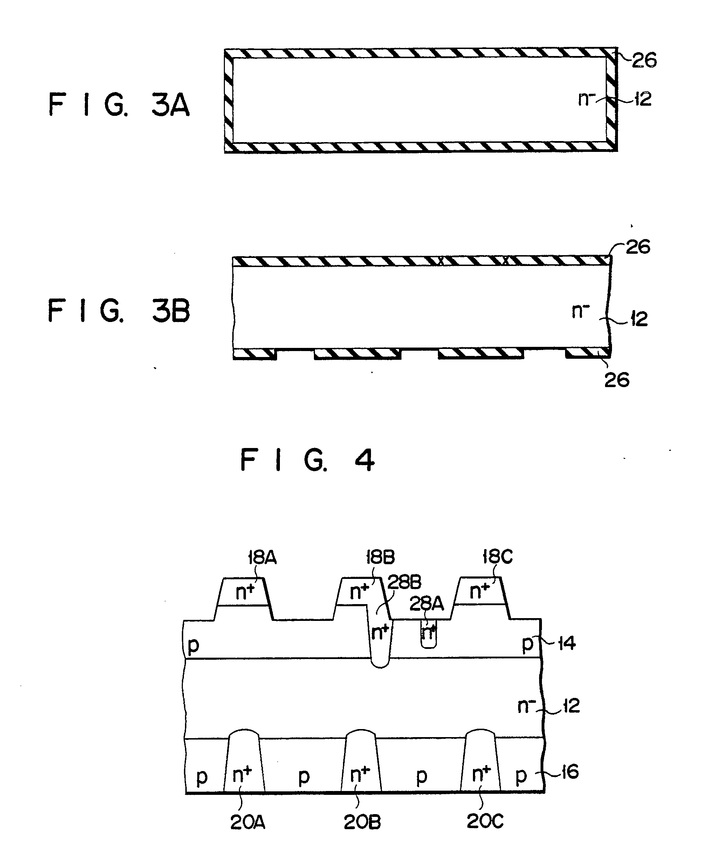

Figs. 3A and 3B shows manufacturing steps for the AN-GTO. In Fig. 3A, oxide film 26 is formed on the entire surface of $n^-$-type substrate 12. Oxide film 26 is patterned on the bottom surface of substrate 12, as shown in Fig. 3B. The $n^+$-type regions 20A through 20C are formed, following the patterning process, by diffusing impurity into the substrate 12 with the mask of the remaining oxide film 26.

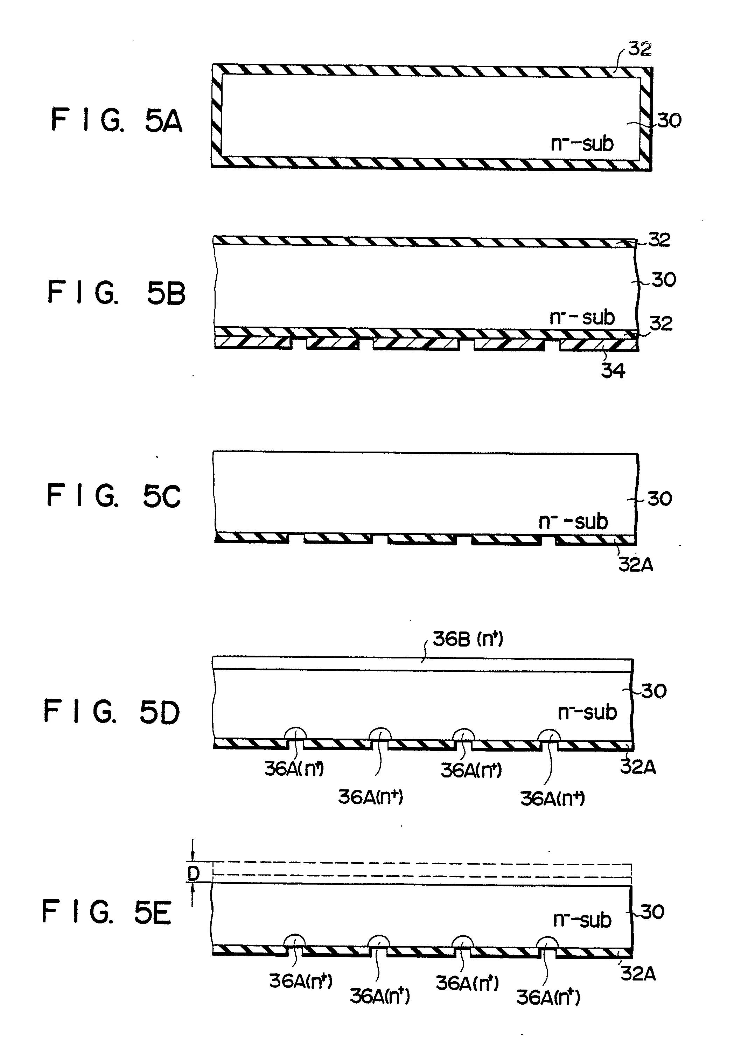

During the manufacturing of the devices, however, pin-hole defects, for example, may occur in oxide film 26 at points indicated by "X" in Fig. 3B, from a variety of causes. In this case, oxide film 26 cannot fulfill its role as a diffusion protecting film, in the forming process of $n^+$-type regions 20. This is because the impurities will pass through the pin-holes and diffuse into substrate 12, thus forming unnecessary $n^+$-type regions. In the succeeding steps of forming p-type region 14, $n^+$-type regions 18, and the like, the unnecessary $n^+$-type regions will be thermally diffused to grow to the size of $n^+$-type regions 28A and 28B, as shown in Fig. 4. $n^+$-type regions 28A and 28B will deteriorate the forward blocking voltage characteristic of the AN-GTO.

Accordingly, an object of the present invention is to provide a method of manufacturing a semiconductor device with excellent forward blocking voltage characteristic at a high production yield.

According to this invention, there is provided a semiconductor device manufacturing method comprising a first step of preparing a semiconductor substrate of a first conductivity type having first and second surfaces, a second step of forming an oxide film pattern on the first surface of the semiconductor substrate, and a third step of forming a first region of the first conductivity type in the first surface of the semiconductor substrate by using a mask of the oxide film pattern, with a higher impurity concentration than the semiconductor substrate, characterized by further comprising a fourth step of removing a part of the semiconductor substrate on the second surface side by a predetermined thickness greater than the depth of the first region; and a fifth step of forming a second region of a second conductivity type in the first surface of the semiconductor substrate with a depth shallower than the first region, after removal of the oxide film pattern, and forming a third region of the second conductivity type in the second surface of the semiconductor substrate.

With the above manufacturing method, even if an unnecessary region of the first conductivity type is formed in the second surface of the semiconductor substrate in the third step, this region formed is reliably removed in the fourth step. Therefore, the forward blocking voltage characteristic of the produced device is prevented from deterioration caused by the growth of such a region. This fact greatly contributes to improvement of the yield of production of semiconductor devices.

This invention can be more fully understood from the following detailed description when taken in conjunction with the accompanying drawings, in which:

Fig. 1 shows a top view of the known AN-GTO;

Fig. 2 shows a partial cross sectional view taken along line I - I shown in Fig. 1;

Figs. 3A and 3B show manufacturing steps of the AN-GTO according to a conventional manufacturing method;

Fig. 4 shows a defective AN-GTO having unnecessary semiconductor regions as manufactured according to the conventional manufacturing method; and

Figs. 5A to 5J illustrate manufacturing steps of an AN-GTO according to an embodiment of this invention.

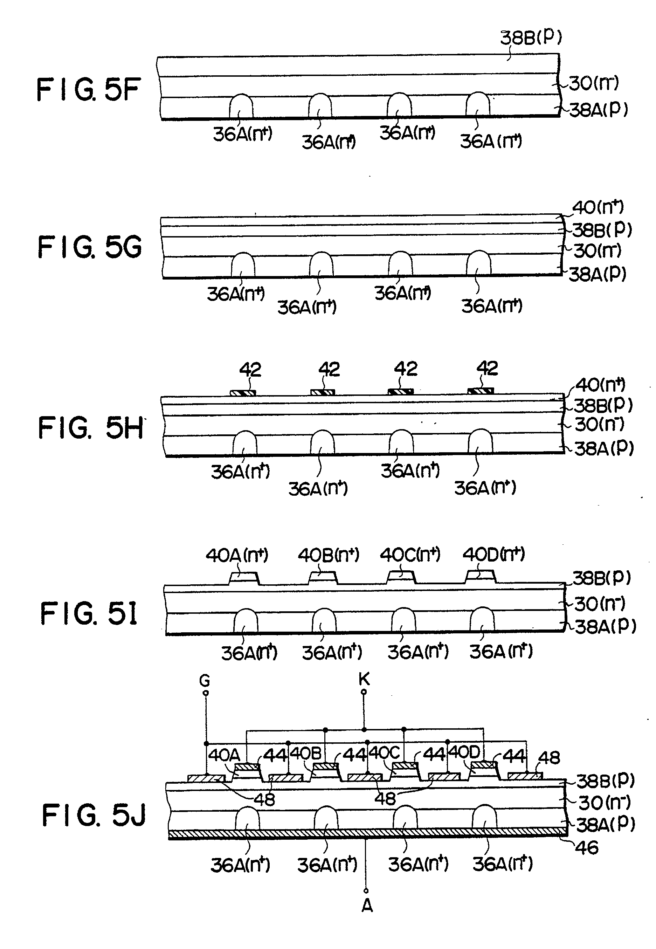

A method for manufacturing a semiconductor device according to an embodiment of this invention will be described referring to Figs. 5A through 5J. These figures illustrate steps for manufacturing an anode shorting type gate turn-off thyristor (AN-GTO). In a first step, $n^-$-type substrate 30 containing n-type impurity at a low concentration is prepared. Oxide film 32 is formed on the substrate 30 with a uniform thickness and covers the entire surface of substrate 30, as shown in Fig. 5A.

After this, resist pattern 34 is formed on oxide film 32 over the bottom surface of substrate 30, as shown in Fig. 5B. Oxide film 32 is subjected to an etching process with a use of resist pattern 34 as a mask. In this process, oxide film 32 is completely removed from the upper surface of substrate 30, and partially removed from the bottom surface, oxide film pattern 32A being left on the bottom surface of substrate 30, as shown in Fig. 5C. Then, n-type impurity, such as phosphorus, is doped in the exposed surface of semiconductor substrate 30, using oxide film pattern 32A as a mask. During the doping process, $n^+$-type diffusion regions 36A and 36B with high impurity concentration are formed in the bottom and top surfaces of substrate 30. Subsequently, substrate 30 is subjected to the lapping process. Through this lapping process, the upper surface area of substrate 30 is lapped away by a predetermined thickness D. The thickness D is so selected to be greater than the depth of diffusion region 36B, as shown in Fig. 5E, in order to completely remove diffusion region 36B from semiconductor substrate 30. The step of Fig. 5E may include an etching process or etching-lapping process instead of the lapping process.

After removal of oxide film pattern 32A, the p-type impurity such as gallium is doped into the substrate 30. By this doping process, p-type diffusion regions 38A and 38B are respectively formed in the bottom and top surfaces of substrate 30, as shown in Fig. 5F. In this case, the amount of doping impurity and the doping time are selected to a value at which the conductivity type of the diffusion regions 36A is not inverted. During this doping, regions 36A grow as shown in Fig. 5F, due to the thermal diffusion of impurities. Diffusion region 38A is formed shallower than diffusion regions 36A as grown in order to use the regions 36A as the anode shorting regions. Following the formation of diffusion region 38B, n-type impurity is doped in the top surface of the semiconductor substrate to form $n^+$-type diffusion region 40 with a uniform thickness, as shown in Fig. 5G.

As shown in Fig. 5H, resist pattern 42 is applied to the top of diffusion region 40, and selectively masks region 40 corresponding to the positions of diffusion regions 36A. After this, an etching process is performed, using the resist pattern 42 as a mask. As shown in Fig. 5I, portions of diffusion regions 40 and 38B are selectively removed through the process. The remaining diffusion regions 40A through 40D are used as the cathode-emitter of the AN-GTO.

Then, as shown in Fig. 5J, cathode electrodes 44 are formed in ohmic contact with diffusion regions 40A through 40D, gate electrodes 48 are formed in contact with diffusion region 38B, and anode electrodes 46 are formed in ohmic contact with diffusion regions 38A and 36A.

According to the manufacturing method of the above-mentioned embodiment, an unnecessary diffusion region 36B is formed by the process of Fig. 5D, but this region has been completely removed before diffusion region 38B is formed. Even if heat is applied to the semiconductor structure in the steps succeeding to the step of Fig. 5F, a shorting portion will not be formed on the cathode side of the AN-GTO. Also, even in case diffusion region 360 is not completely removed, as long as region 36B grows in diffusion region 38B, the deterioration of a forward blocking electrical characteristic of the AN-GTO will be prevented.

According to this embodiment, it is not necessary to leave oxide film 32 on the top surface of semiconductor substrate 30 in the etching process of the oxide film 32. On the other hand, in the conventional manufacturing method, in order for oxide film 32 to perform its role as a diffusion protective film on the top surface of semiconductor substrate 30, a resist film must be applied beforehand to the top of the protective film, so that it will not be removed by the etching process.

## Claims

1. A semiconductor device manufacturing method comprising:

a first step of preparing a semiconductor substrate (30) of a first conductivity type having first and second surfaces;

a second step of forming an oxide film pattern (32A) on the first surface of said semiconductor substrate (30); and

a third step of forming a first region (36A) of the first conductivity type in the first surface of said semiconductor substrate (30) by using a mask of said oxide film pattern (32A), with a higher impurity concentration than said semiconductor substrate;

characterized by further comprising

a fourth step of removing a part of said semiconductor substrate (30) on the second surface side by a predetermined thickness greater than the depth of said first region (36A); and

a fifth step of forming a second region (38A) of a second conductivity type in said first surface of said semiconductor substrate (30) with a depth shallower than said first region (36A) after removal of said oxide film pattern (32A), and forming a third region (38B) of the second conductivity type in the second surface of said semiconductor substrate (30).

**2.** A method according to claim 1,
characterized in that said fourth step includes a lapping process for lapping the second surface of said semiconductor substrate (30).

**3.** A method according to claim 2,
characterized in that said fourth step includes an etching process for etching the second surface of said semiconductor substrate after said lapping process.

**4.** A method according to claim 1,
characterized in that said second step includes a substep of forming an oxide film (32) of a uniform thickness covering the entire surface of said semiconductor substrate (30), a substep of forming a resist pattern (34) on the oxide film (32) over the first surface of said substrate (30), and a substep of removing the unmasked portions of said oxide film (32) after the formation of said resist pattern (34).

**5.** A method according to claim 1,
characterized by further comprising a sixth step of forming a fourth region (40A; 40B; 40C; 40D) of the first conductivity type on said third region (38B).

**6.** A method according to claim 5,
characterized in that said sixth step includes a substep of forming a layer (40) of the first conductivity type entirely covering said third region (38B), and a substep of selectively etching said layer (40) to leave part of said layer (40) at the location corresponding to said first region (36A), said layer part left serving as said fourth region (40A; 40B; 40C; 40D).

**7.** A method according to claim 5,
characterized by further comprising a seventh step for forming a first electrode (46) in ohmic contact with said first and second regions (36A, 38A), a second electrode (48) in ohmic contact with said third region (38B), and a third electrode (44) in ohmic contact with said fourth region (40A; 40B; 40C; 40D).

**Revendications**

**1.** Procédé de fabrication d'un dispositif semiconducteur comprenant :
une première étape de préparation d'un substrat semiconducteur (30) d'un premier type de conductivité qui comporte des première et seconde surfaces ;
une seconde étape de formation d'un motif de film d'oxyde (32A) sur la première surface dudit substrat semiconducteur (30) ; et
une troisième étape de formation d'une première région (36A) du premier type de conductivité dans la première surface dudit substrat semiconducteur (30) en utilisant un masque dudit motif de film d'oxyde (32A), avec une concentration en impureté supérieure à celle dudit substrat semiconducteur ;
caractérisé en ce qu'il comprend en outre :
une quatrième étape d'enlèvement d'une partie dudit substrat semiconducteur (30) sur le second côté de surface, et ce sur une épaisseur prédéterminée supérieure à la profondeur de ladite première région (36A) ; et
une cinquième étape de formation d'une seconde région (38A) d'un second type de conductivité dans ladite première surface dudit substrat semiconducteur (30) avec une profondeur moins grande que celle de ladite première région (36A) après enlèvement dudit motif de film d'oxyde (32A) et formation d'une troisième région (38B) du second type de conductivité dans la seconde surface dudit substrat semiconducteur (30).

**2.** Procédé selon la revendication 1, caractérisé en ce que ladite quatrième étape inclut un processus de polissage qui permet de polir la seconde surface dudit substrat semiconducteur (30).

**3.** Procédé selon la revendication 2, caractérisé en ce que ladite quatrième étape comporte un processus de gravure pour graver la seconde surface dudit substrat semiconducteur après ledit processus de polissage.

**4.** Procédé selon la revendication 1, caractérisé en ce que ladite seconde étape comporte une sous-étape de formation d'un film d'oxyde (32) d'une épaisseur uniforme qui recouvre la totalité de la surface dudit substrat semiconducteur (30), une sousétape de formation d'un motif de résine (34) sur le film d'oxyde (32) sur la première surface dudit substrat (30) et une sous-étape d'enlèvement des parties non masquées dudit film d'oxyde (32) après la formation dudit motif de résine (34).

**5.** procédé selon la revendication 1, caractérisé en ce qu'il comprend en outre une sixième étape de formation d'une quatrième région (40A, 40B, 40C, 40D) du premier type de conductivité sur ladite troisième région (38B).

**6.** Procédé selon la revendication 5, caractérisé en ce que ladite sixième étape comporte une sous-étape de formation d'une couche (40) du premier type de conductivité qui recouvre en totalité ladite troisième région (38B) et une sous-étape de gravure sélective de ladite couche (40) pour laisser une partie de ladite couche (40) au niveau de l'emplacement qui correspond à ladite première région (36A), ladite partie de couche ainsi laissée servant de dite quatrième région (40A, 40B, 40C, 40D).

7. Procédé selon la revendication 5, caractérisé en ce qu'il comprend en outre une septième étape qui permet de former une première électrode (46) en contact ohmique avec lesdites première et seconde régions (36A, 38A), une seconde électrode (48) en contact ohmique avec ladite troisième région (38B) et une troisième électrode (44) en contact ohmique avec ladite quatrième région (40A, 40B, 40C, 40D).

## Ansprüche

1. Verfahren zum Herstellen einer Halbleiteranordnung mit:

   einem ersten Schritt des Vorbereitens eines Halbleitersubstrats (30) eines ersten Leitfähigkeitstyps mit einer ersten und einer zweiten Oberfläche;

   einem zweiten Schritt des Ausbildens eines Oxidfilmmusters (32A) auf der ersten Oberfläche des Halbleitersubstrats (30); und

   einem dritten Schritt des Ausbildens einer ersten Region (36A) des ersten Leitfähigkeitstyps in der ersten Oberfläche des Halbleitersubstrats (30) durch Verwendung einer Maske des Oxidfilmmusters (32A), mit einer höheren Verunreinigungskonzentration als das Halbleitersubstrat;

   dadurch **gekennzeichnet**, daß es ferner umfaßt:

   einen vierten Schritt des Entfernens eines Teils des Halbleitersubstrats (30) auf der zweiten Oberflächenseite um eine vorgegebene Dicke größer als die Tiefe der ersten Region (36A); und

   einen fünften Schritt des Ausbildens einer zweiten Region (38A) eines zweiten Leitfähigkeitstyps in der ersten Oberfläche des Halbleitersubstrats (30) mit einer Tiefe flacher als die erste Region (36A) nach Entfernung des Oxidfilmmusters (32A), und des Ausbildens einer dritten Region (38B) des zweiten Leitfähigkeitstyps in der zweiten Oberfläche des Halbleitersubstrats (30).

2. Verfahren nach Anspruch 1, dadurch **gekennzeichnet**, daß der vierte Schritt einen Schleifprozeß zum Schleifen der zweiten Oberfläche des Halbleitersubstrats (30) umfaßt.

3. Verfahren nach Anspruch 2, dadurch **gekennzeichnet**, daß der vierte Schritt einen Ätzprozeß zum Ätzen der zweiten Oberfläche des Halbleitersubstrats nach dem Schleifprozeß umfaßt.

4. Verfahren nach Anspruch 1, dadurch **gekennzeichnet**, daß der zweite Schritt einen Unterschritt des Ausbildens eines Oxidfilms (32) mit gleichförmiger Dicke, der die gesamte Oberfläche des Halbleitersubstrats (30) bedeckt, einen Unterschritt des Ausbildens eines Widerstandsmusters (34) auf dem Oxidfilm (32) über der ersten Oberfläche des Substrats (30) und einen Unterschritt des Entfernens der unmaskierten Teile des Oxidfilms (32) nach der Ausbildung des Widerstandsmusters (34) umfaßt.

5. Verfahren nach Anspruch 1, **gekennzeichnet** ferner durch einen sechsten Schritt des Ausbildens einer vierten Region (40A; 40B; 40C; 40D) des ersten Leitfähigkeitstyps auf der dritten Region (38B).

6. Verfahren nach Anspruch 5, dadurch **gekennzeichnet**, daß der sechste Schritt einen Unterschritt des Ausbildens einer Schicht (40) des ersten Leitfähigkeitstyps, die die dritte Region (38B) vollständig bedeckt, und einen Unterschritt des selektiven Ätzens der Schicht (40) umfaßt, um einen Teil der Schicht (40) an der der ersten Region (36A) entsprechenden Stelle zu lassen, wobei der zurückgelassene Schichtteil als vierte Region (40A; 40B; 40C; 40D) dient.

7. Verfahren nach Anspruch 5, **gekennzeichnet** ferner durch einen siebten Schritt des Ausbildens einer ersten Elektrode (46) in ohmschem Kontakt mit der ersten und der zweiten Region (36A, 38A), einer Elektrode (48) in ohmschem Kontakt mit der dritten Region (38B) und einer dritten Elektrode (44) in ohmschem Kontakt mit der vierten Region (40A; 40B; 40C; 40D).

# F I G. 1

# F I G. 2

F I G. 3A

26

$n^-$  12

F I G. 3B

26

$n^-$  12

26

F I G. 4

18A          18B      28B          18C

$n^+$        $n^+$      28A        $n^+$

$n^+$    $n^+$

p                                      p  14

$n^-$  12

p  $n^+$  p  $n^+$  p  $n^+$  p  16

20A          20B          20C

F I G. 5A

32

30

n$^-$-sub

F I G. 5B

32

30

n$^-$-sub

32

34

F I G. 5C

30

n$^-$-sub

32A

F I G. 5D

36B (n$^+$)

30

n$^-$-sub

36A(n$^+$)  36A(n$^+$)  36A(n$^+$)  36A(n$^+$)

32A

F I G. 5E

D

30

n$^-$-sub

36A(n$^+$)  36A(n$^+$)  36A(n$^+$)  36A(n$^+$)

32A

FIG. 5F

38B(P)
30(n⁻)
38A(P)
36A(n⁺)  36A(n⁺)  36A(n⁺)  36A(n⁺)

FIG. 5G

40(n⁺)
38B(P)
30(n⁻)
38A(P)
36A(n⁺)  36A(n⁺)  36A(n⁺)  36A(n⁺)

FIG. 5H

42  42  42  42
40(n⁺)
38B(P)
30(n⁻)
38A(P)
36A(n⁺)  36A(n⁺)  36A(n⁺)  36A(n⁺)

FIG. 5I

40A(n⁺)  40B(n⁺)  40C(n⁺)  40D(n⁺)
38B(P)
30(n⁻)
38A(P)
36A(n⁺)  36A(n⁺)  36A(n⁺)  36A(n⁺)

FIG. 5J

G  K
40A  44  40B  44  40C  44  40D  44  48
38B(P)
48  48
30(n⁻)
38A(P)
46
36A(n⁺)  36A(n⁺)  36A(n⁺)  36A(n⁺)
A